# EUROPEAN PATENT APPLICATION

(11) **EP 2 051 569 A2**
(43) Date of publication of application: **22.04.2009**
(21) Application number: 08166516.8
(22) Date of filing: 13.10.2008
(51) Int. Cl.: H05K 1/02

(54) **Laminated printed wiring board with controlled spurious rf emission capability/characteristics**

(30) Priority: 17.10.2007 US 874103
(71) Applicant: Honeywell International Inc., Morristown, NJ 07962 (US)
(72) Inventor: Patten, Charles B., Sammamish, WA 98074 (US); Vacanti, David C., Renton, WA 98058 (US)
(74) Representative: Buckley, Guy Julian

(57) **Abstract**

Printed wiring board for generally reducing electro-magnetic, capacitive and inductive cross coupling and cross talk in electrical circuits, electronic modules, and systems utilizing dissipative carbon layers residing between layers of conventional analog, digital, radio frequency (RF), or assemblies of mixed circuitry printed wiring constructions. Connection between layers by the use of insulated vias is possible when connection to the carbon layer is not desired.

## Description

### BACKGROUND OF THE INVENTION

The prior art focuses on resistive, inductive, or capacitive forms of noise (or emission) suppression by directly addressing the frequency or amplitude of the unwanted emission with specific circuitry elements directed at that noise or emission.

The prior art is only motivated for providing circuitry elements on the surface of a printed wiring board for suppressing noise.

### SUMMARY OF THE INVENTION

The present invention provides printed wiring assemblies having two or more layers constructed to reduce unwanted electrical signal interference internal to and radiating from the assembly. One of the layers is a material that absorbs electrically radiated signals from circuit elements and dissipates their energy a lossy conductive material as heat. Electrical signals that are strong enough to penetrate through the lossy conductive material without being completely dissipated will generally be reflected back to the lossy conductive material by adjacent surfaces or structure where they will face further attenuation. Inclusion of features of this invention also reduces noise from other circuit assemblies that have sufficient energy to penetrate to the lossy conductive layer. The lossy conductive layer can be constructed of discrete layers of materials bonded to form a sandwich or can be applied as a discrete layer via screen printing or deposition directly upon the desired printed circuit board layer, in continuous or targeted formats. Multilayer printed wiring board interconnection is also possible using plated through and filled VIAs common to printed wiring board construction.

The absorbing material that includes the lossy conductive layer includes forms of carbon, such a carbon black, carbon fibers or carbon Microspheres that reside between layers of conventional analog, digital, radio frequency (RF), or assemblies of mixed circuitry printed wiring constructions. The carbon layer is arranged in continuous, segmented, and or combinations to provide controlled conductive and dissipative regions tailored to individual design needs. This technology is suited to polytetraflouroethylene (PTFE) boards constructed with metallic sheet layers on one or both sides in conventional, RF distributed impedance or lumped impedance configurations including etched and discrete micro-strip circuitry. This technology is similarly suited to common materials used for laminated printed wiring boards for electronic construction including high frequency digital construction and layout, including a combination of digital and RF circuitry, either on one continuous layer or multiple layers interleaved by one or more carbon layers, with or without additional metallic layers or ground plane layers. This application allows connection between layers by the use of VIAs and/or isolated traps when connection to the carbon layer is not desired for that connection. These VIAs and layers also can provide for thermal as well as electrical paths of conduction.

### BRIEF DESCRIPTION OF THE DRAWINGS

Preferred and alternative embodiments of the present invention are described in detail below with reference to the following drawings:

FIGURE 1 is a cross-sectional view representative of a typical partial stackup of mixed signal, digital, and or RF sections in accordance with an embodiment of the present invention;

FIGURE 2 is a cross-sectional view of another embodiment;

FIGURES 3A, B are cross-sectional perspective views illustrative of various embodiments of the present invention; and

FIGURES 4A, B are perspective views of stacked configurations according to an embodiment of the present invention illustrative of methods that facilitate removal of heat from the circuit board assembly where thermal considerations are of concern to the designer.

### DETAILED DESCRIPTION OF THE PREFERRED EMBODIMENT

The detailed structure of the elements of the several embodiments described above in the brief description of the drawings are illustrative of the multi-layered printed wiring board configurations that reduce electro-magnetic, capacitive and inductive cross coupling and cross talk in electrical circuits, electronic modules and systems by utilizing dissipative carbon layers residing between layers of conventional analog, digital, radio frequency, or assemblies of mixed printed circuit wiring constructions.

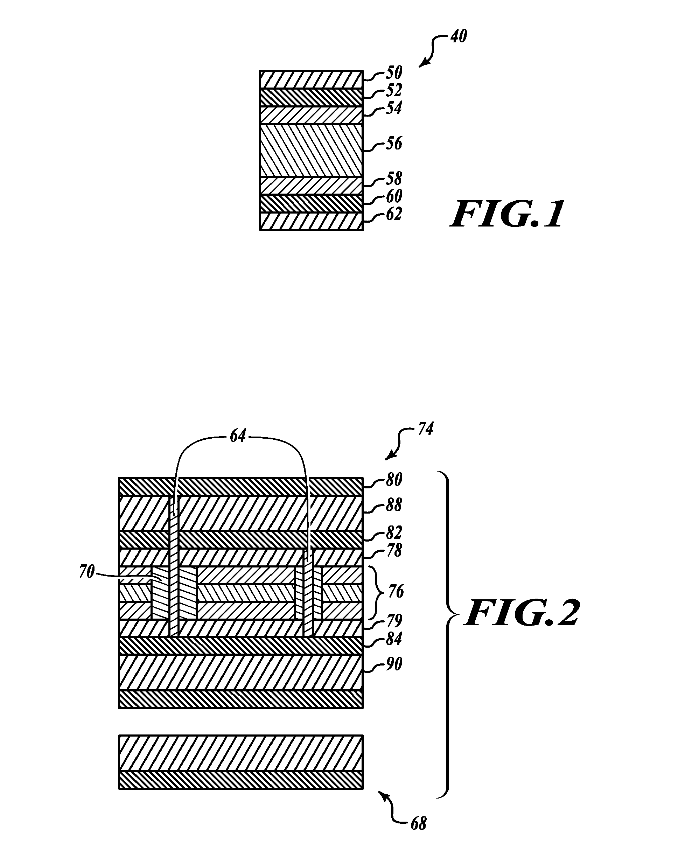

The embodiment shown in FIGURE 1 illustrates a die stackup 40 that includes components for producing mixed, digital and/or RF signals. The die stackup 40 is a sandwich structure at, in one embodiment, includes a layer of insulating material 50, a patterned or continuous layer of metallic (or printed circuit) material (optional) 52, a carbon-based material (optional) layer 54, a carbon microsphere layer 56, a second carbon-based material (optional) layer 58 (lossy carbon layers 54-58), a patterned or continuous layer of metallic (or printed circuit) material (optional) 60, and a second insulating layer 62.

Active components (now shown) are included in subsequent layers that are applied over the insulating layers 50, 62. The carbon based material layers 54, 58 and the carbon microsphere layer 56 absorb signals produced by the active components that are located on opposing sides of the die stackup 40. The printed circuit material layers 52, 60 provide a heat sink for any heat produced by the carbon layers 54-58 as a result of signal absorption.

In one embodiment, the carbon layers 54-58 include carbon, such as that found in carbon paper, and possibly Nickel combined with a bonding agent, e.g. resins (Polyetherimide (PIE), Polyethersulfone (PES)). The carbon layers 54-58 provide lossy RF dissipation. If Ni is included, then a level of magnetic field absorption occurs. The carbon layers 54-58 are bonded (e.g. thermal, pressure) to metallic material layers. An epoxy (e.g. preform) may be used in the bonding process.

In another embodiment, the carbon layers 54-58 include only a layer of carbon microspheres or any combination of layers of carbon microspheres and non-microshpere carbon layers (54, 58). Carbon Microspheres are a specialty product of Honeywell Intl, Great Bend, Indiana.

The embodiment shown in FIGURE 2 shows electrical interconnection between active layers while selectively isolating those active layers from any carbon layers. A multi-level circuit board 74 includes a carbon-based core (lossy carbon layer) 76 having insulator layers 78, 79 being bonded to top and bottom surfaces. A printed metal ground plane layer 82 and a printed circuit material layers 84 are created on or bonded to the respective insulator layers 78, 79. Other insulator layers 88, 90 are attached to the printed metal ground plane layer 82 and the printed circuit material layers 84 A printed circuit material layer 80 is attached to the insulating layer 88 that is attached to the printed metal ground plane layer 82.

In order to provide electrical signal transmission between the printed circuit material layers 80 and 82 on one side of the carbon-based core (lossy carbon material layer) 76 and the printed circuit material layers 84 on other side of the carbon-based core 76, then one or more vias 70 are formed through any insulating layers and the carbon-based core 76. The via that carries a signal or power through the carbon based core 76 would make electrical contact with the carbon core 76. Therefore, various means are employed to insulate conductive vias from the carbon core 76. For example, pre-drilling or selectively depositing the carbon core 76 is performed such that the carbon core 76 is held back a distance (at least two times the radius of the via hole) from the edge of the via. Non conducting vias may also be transited by insulated wire leads or other means. Electrical leads 64 may also be inserted into the vias 70 and connected to the desired the printed circuit material layers. The vias 70 may be filed with an insulator material or may be left unfilled. This interconnection between layers may also be used provide improved heat sinking capabilities.

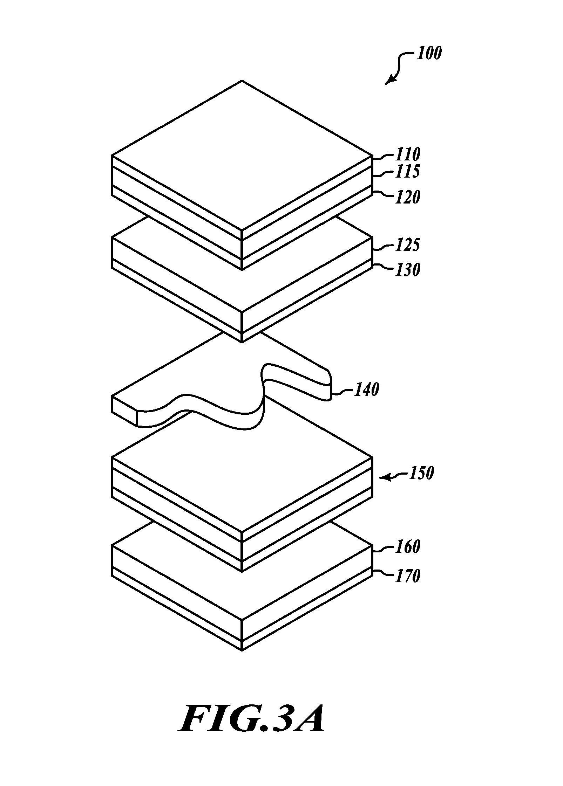

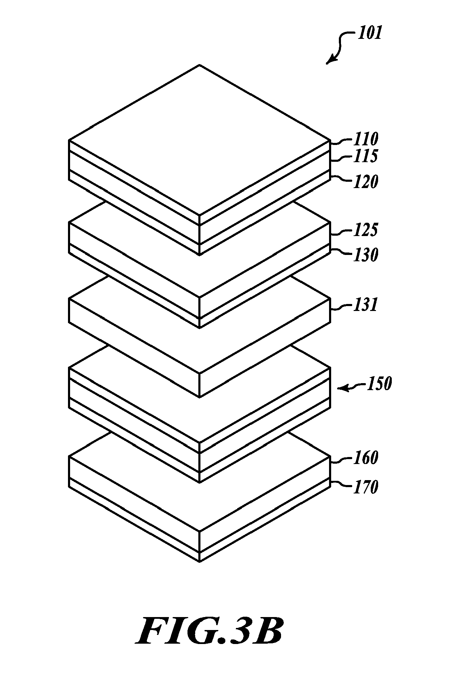

FIGURES 3A and 3B illustrate an exploded view of example multi-layered printed wiring boards 100, 101. The board 100 is created using screen printed and/or deposition of material in both non-insulated and insulated multi-layer configurations. Also an insulated/electrically isolated multi-layer construction detail is shown through the use of insulating material to prevent the lossy carbon layer 150 from physically contacting the circuitry of the printed circuit layers on either side. The board 100 shown in FIGURE 3A includes a first wafer having a printed circuit material layer 110 on an insulating layer 115 on a printed circuit material layer 120. The printed circuit layer 120 is then bonded to another wafer having an insulating layer 125 on a printed circuit material layer 130. The printed circuit layer 130 is bonded to a partial lossy carbon material 140 that has been patterned according to a predefined pattern. The layers 120, 130 may be metal ground plane layers. Attached to the lossy carbon material 140 is another lossy carbon material layer 150 that includes top and bottom layers with an internal layer. The top and bottom layers may be similar to layers 54, 58 of FIGURE 1. The internal layer may be similar to the layer 58 of FIGURE 1. The lossy carbon material layer 150 is bonded on the other side to a wafer having an insulating layer 160 and a printed circuit layer 170.

FIGURE 3B shows an additional insulating layer 131 that is bonded to the conducting material layer 130 and the layered composite 150. The patterned composite material 140 is not present.

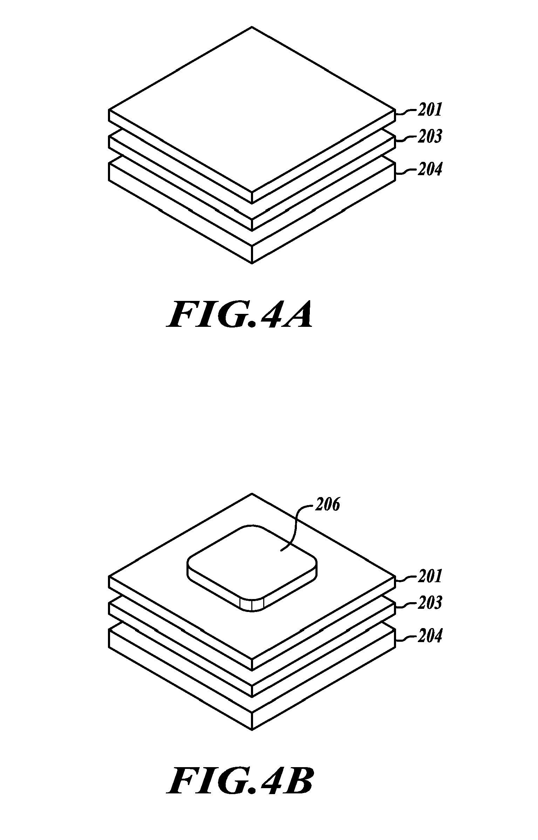

FIGURES 4A and 4B illustrate part of an example thermal stackup. FIGURE 4A illustrates a thermally conductive metal layer 201 on an insulating layer 203 that is bonded to a composite material 204. FIGURE 4B includes a mechanical interface 206 for discrete devices (e.g., sensors). The mechanical interface 206 provides a platform for thermally, electrically and mechanically connecting devices to the thermally conducting material layer 201.

When the carbon layer absorbs electromechanical signals it will heat up, but not enough to be readily measured. The power dissipated is on the order of milliwatts or microwatts (0.001 to 0.000,001 Watts).

The following are example layering patterns produced in accordance with embodiments of the present invention.

Pattern 1:

Metal Circuits

Insulator

Carbon

Ground plane

Insulator

Metal Circuits

Insulator

Carbon

etc

Patten 1 is useable for analog and digital circuitry.

Pattern 2:

Metal Circuits

Insulator

Ground Plane

Carbon

Ground plane

Insulator

Metal Circuits

In Pattern 2, the two grounds are tied together via the carbon layer (lossy material). This prevents capacitive coupling from taking place. The carbon will dissipate differential currents - those currents that are not common to the two sides. Pattern 2 can be used for RF circuits as well as analog and digital. The stack may be modified to include at least one insulator on one or both sides of the carbon to keep the two ground planes isolated from each other with the carbon providing dissipative shielding - see Pattern 3.

Pattern 3:

Metal Circuits

Insulator

Ground Plane

Insulator

Carbon

Insulator (Optional)

Ground plane

Insulator

Metal Circuits

The stacking as described can be repeated as many times as necessary.

The embodiments of the invention in which an exclusive property or privilege is claimed are defined as follows:

## Claims

1. A multi-layered printed wiring board comprising:
a first section comprising at least one layer of printed circuit material configured to include one or more electromagnetic emanating components;
a signal absorbing layer; and
a second section comprising at least one layer of printed ground plane or printed circuit material configured to include one or more circuit components,
wherein a first side of the signal absorbing layer is bonded to a first side of the first section and a second side of the signal absorbing layer is bonded to a first side of the second section, the signal absorbing layer is configured to absorb at least a portion of electromagnetic signals produced by the electromagnetic emanating components.

2. The multi-layered printed wiring board of Claim 1, wherein the signal absorbing layer is a lossy carbon layer, the lossy carbon layer includes at least one of carbon black, carbon fiber, or carbon microspheres, and the lossy carbon layer comprises at least one layer having nickel coated carbon microspheres.

3. The multi-layered printed wiring board of Claim 1, wherein the signal absorbing layer is a lossy carbon layer, the lossy carbon layer comprises a bonding agent, and the bonding agent comprises a resin.

4. The multi-layered printed wiring board of Claim 1, wherein the signal absorbing layer is a lossy carbon layer, further comprising:
one or more vias through and electrically insulated from the lossy carbon layer; and
one or more leads or metal plated vias configured to electrically connect the first section to the second section while insulated from the lossy carbon layer.

5. The multi-layered printed wiring board of Claim 1, wherein the signal absorbing layer is a lossy carbon layer, the first and second sections comprise one or more insulating layers and one of the insulating layers is located between the lossy carbon layer and the printed circuit material layer of the first section and one of the insulating layers is located between the lossy carbon layer and the printed ground plane or printed circuit material layer of the second section, further comprising a sixth section comprising an insulating layer and a printed circuit material layer being bonded to the second section, wherein when bonded the insulating layer is adjacent to the printed ground plane layer of the second section.

6. A method for making a printed wiring board for suppressing electromagnetic emanations from circuit components located thereon, the method comprising:
providing a first section comprising at least one layer of printed circuit material configured to receive one or more circuit components;
bonding a second section comprising one layer of insulating material to the first section;
bonding a third section comprising a printed ground plane layer to the second section; and
providing a fourth section comprising at least one layer of signal absorbing lossy carbon material, the fourth section being bonded to the third section,
providing a fifth section comprising at least one printed ground plane layer or insulating layer, the fifth section being bonded to the fourth section;
wherein the signal absorbing lossy carbon layer is configured to absorb at least a portion of electromagnetic signals produced by at least one of the circuit components and is indirectly bonded to the printed ground plane layer.

7. The method of Claim 6, further comprising:
forming one or more leads or metal plated vias through the lossy carbon layer, wherein the one or more leads or metal plated vias are electrically insulated from the lossy carbon layer; and
connecting one of the leads or metal plated vias between at least two of the first, third, and fifth sections.

8. The method of Claim 6, wherein the lossy carbon layer comprises at least one layer having carbon microspheres.

9. The method of Claim 6, further comprising an insulating layer bonded between the third and fourth sections.

10. The method of Claim 6, further comprising bonding more layers of one of carbon, insulating material, ground plane material, or printed circuit material provided any carbon layers are isolated from the printed circuit material.
